# EUROPÄISCHE PATENTSCHRIFT

(11) **EP 3 721 519 B1**
(45) Veröffentlichungstag und Bekanntmachung des Hinweises auf die Patenterteilung: **01.06.2022**
(21) Anmeldenummer: 18814840.7
(22) Anmeldetag: 30.11.2018
(51) Int. Cl.: H02H 7/20, H02H 3/33, H02H 11/00, H02H 3/00, H02S 50/00

(54) **FEHLABSCHALTSICHERES BETRIEBSVERFAHREN FÜR EINE DEZENTRALE ENERGIEERZEUGUNGSANLAGE**
FAIL-SAFE OPERATING METHOD FOR A LOCAL POWER GENERATION PLANT
PROCÉDÉ FONCTIONNEMENT PROTÉGÉ CONTRE LES ARRÊTS INTEMPESTIFS POUR INSTALLATION DE PRODUCTION D'ÉNERGIE DÉCENTRALISÉE

(30) Priorität: 06.12.2017 DE 102017129083
(43) Veröffentlichungstag der Anmeldung: 14.10.2020
(73) Patentinhaber: SMA Solar Technology AG, 34266 Niestetal (DE)
(72) Erfinder: VIOTTO, Michael, 34128 Kassel (DE); PUTZ, Martin, 34119 Kassel (DE); TSCHENDEL, Christian, 34121 Kassel (DE)
(86) Internationale Anmeldenummer: PCT/EP2018/083229
(87) Internationale Veröffentlichungsnummer: WO 2019/110454

(56) Entgegenhaltungen:
- EP-A1- 2 375 552
- EP-A2- 0 878 850
- WO-A1-2012/098677
- DE-A1-102015 101 870

## Beschreibung

Die Erfindung betrifft ein Betriebsverfahren für eine dezentrale Energieerzeugungsanlage mit dem Ziel, ein unnötiges Abschalten der dezentralen Energieerzeugungsanlage aufgrund eines zu hohen Fehlerstromes zu vermeiden, sowie eine dezentrale Energieerzeugungsanlage, die zur Ausführung dieses Verfahrens eingerichtet ist.

Dezentrale Energieerzeugungsanlagen (im Folgenden kurz DEA genannt), insbesondere Photovoltaikanlagen, sind häufig mit einer Fehlerstromschutzschaltung ausgestattet, die eine Verbindung der DEA mit einem Netz auftrennt, wenn eine Differenz zwischen der Summe der aus der DEA fließenden und der Summe der in die DEA fließenden Ströme einen Grenzwert übersteigt. Eine solche Grenzwertüberschreitung des Fehlerstroms hat möglicherweise eine mangelhafte Isolation der spannungsführenden Komponenten gegenüber dem Erdpotential zur Ursache und kann beispielsweise durch versehentliche Berührung einer spannungsführenden Leitung durch eine Person begründet sein. Häufig ist normativ gefordert, dass nach einem Abschalten der Anlage ein Zuschalten erst nach einer Überprüfung der Anlage durch Wartungspersonal erlaubt ist, so dass die Anlage nach einem Abschalten über einen längeren Zeitraum keine Energie in das Netz einspeisen kann, selbst wenn eine andere Ursache zum Abschalten der Anlage geführt hat und ein gefahrloses Wiederverbinden mit dem Netz möglich wäre.

Gleichzeitig weisen gerade bei transformatorlosen Wechselrichtern als Bestandteil einer DEA die Verbindungsleitungen zu einem Generator der DEA bauartbedingt eine netzfrequente Variation des Leitungspotentials gegenüber Erde auf, so dass eine netzfrequente Ableitstromkomponente entsteht, die von der Höhe der Ableitkapazität des Generators gegenüber Erde abhängt. Bei einem hohen Wert der Ableitkapazität kann die netzfrequente Ableitstromkomponente eine Amplitude annehmen, die zu einem frühzeitigen Auslösen der Fehlerstromschutzschaltung führt. Der Wert der Ableitkapazität hängt hierbei von der Größe des Generators sowie auch von dessen Montageweise ab und ist darüber hinaus auch stark abhängig von den Wetterbedingungen. Insbesondere bei Nässe steigt die Ableitkapazität einer DEA stark an und kann dazu führen, dass bei diesen Wetterbedingungen die Fehlerstromschutzschaltung regelmäßig aufgrund hoher Ableitströme, die fälschlicherweise als unzulässige Fehlerströme erkannt werden, und damit unnötig auslöst.

Daher existieren zur Vermeidung der beschriebenen vorzeitigen Auslösung der Fehlerstromschutzschaltung diverse Ansätze. So schlägt die Schrift GB 2 258 095 A vor, den Fehlerstrom in eine Gleichstromkomponente, eine erste netzfrequente Stromkomponente, die in Phase mit einer Frequenz des Netzes ist, und eine zweite netzfrequente Ableitstromkomponente aufzuteilen, die 90° phasenverschoben zu einer Frequenz des Netzes ist. Den unterschiedlichen Komponenten werden unterschiedliche Schwellwerte zugeordnet, bei deren Überschreitung sich die DEA vom Netz trennt.

Demgegenüber schlägt die Schrift EP 0 878 850 A2 vor, eine Anlage nur so auszulegen, dass die Ableitkapazität des Generators einer DEA einen vorgegebenen, aus einer Auslöseschwelle einer Fehlerstromschutzschaltung errechneten Wert nicht überschreitet. Hierdurch werden die Größe des Generators und damit die Anlagenleistung eingeschränkt.

Die Schrift WO2012/098677 offenbart ein Verfahren zur Isolationswiderstands-Bestimmung einer an einen Leistungswandler angeschlossenen Quelle. Durch die Wahl von zwei unterschiedlichen Dauern eines Messzeitintervalls wird ein Einfluss einer Ableitkapazität auf die Messung variiert. Bei Verwendung des kurzen Messintervalls wird vorgeschlagen, eine Marge für den Isolations-Schwellwert vorzusehen, der zum Zuschalten eines Leistungswandlers mit der Quelle zu unterschreiten ist.

Ein weiterer bekannter Lösungsansatz besteht darin, in eine der durch einen Fehlerstromsensor der Fehlerstromschutzschaltung überwachten Netzanschlussleitungen einen netzfrequenten Kompensationsstrom einzuspeisen, der die netzfrequente Ableitstromkomponente ausgleicht, beziehungsweise den Kompensationsstrom in eine zusätzliche, durch den Fehlerstromsensor hindurchgeführten Leitung oder Wicklung einzuprägen. Der Kompensationsstrom muss über eine Regelvorrichtung dem jeweiligen Betriebszustand der Anlage angepasst werden.

Im Lichte des bekannten Standes der Technik besteht ein Bedarf nach einer kostengünstigen und zuverlässigen Fehlerstromüberwachung, die robust gegen wetterbedingtes Fehlauslösen der Fehlerstromschutzschaltung ist und die Auslegung der DEA nicht unnötig einschränkt. Die Erfindung hat die Aufgabe, diesen Bedarf zu erfüllen.

Diese Aufgabe wird gelöst durch ein Betriebsverfahren mit den Merkmalen des Anspruchs 1, sowie durch eine DEA gemäß Anspruch 12. Bevorzugte Ausführungsformen der Erfindung sind in den abhängigen Ansprüchen beschrieben.

Ein fehlabschaltsicheres Betriebsverfahren für eine dezentrale Energieerzeugungsanlage DEA umfasst die Schritte:
- vor einem Verbinden der DEA mit einem Netz, Bestimmen einer Ableitkapazität eines Generators der DEA,
- Vergleichen der bestimmten Ableitkapazität mit einem vorgegebenen ersten Grenzwert, und
- Verbinden der DEA mit dem Netz nur dann, wenn die bestimmte Ableitkapazität kleiner als der vorgegebene erste Grenzwert ist.

Durch das bedingte Verbinden mit dem Netz bleibt eine netzfrequente Ableitstromkomponente, die durch die Ableitkapazität verursacht ist, derart limitiert, dass sie klein bleibt gegenüber dem Schwellwert, bei dem eine Fehlerstromschutzschaltung auslöst und die DEA vom Netz trennt. Die Bedingung stellt dabei sicher, dass in Betriebssituationen, in denen die Ableitstromkomponente einen signifikanten Anteil des Schwellwerts darstellt - die Abschaltungsmarge somit signifikant reduziert, so dass die Wahrscheinlichkeit hoch ist, dass die Fehlerstromschutzschaltung unnötiger Weise anspricht - die DEA vom Netz getrennt verbleibt und erst dann einschaltet, wenn die Bedingung wieder erfüllt ist. Es hat sich in der Praxis herausgestellt, dass der Ertragsverlust dadurch, dass die DEA bei Nichterfüllen der Bedingung zeitweise vom Netz getrennt verbleibt, gering ist gegen den Ertragsverlust, der aufgrund eines Anlagenstillstandes durch eine unnötige Auslösung der Fehlerstromschutzschaltung bis zur manuellen Prüfung der DEA verursacht wird.

Gleichzeitig ist es nicht erforderlich, diese Ableitstromkomponente bei der Bestimmung eines Fehlerstroms aufwändig zu kompensieren oder anderweitig zu berücksichtigen. Die Fehlerstromschutzschaltung kann dadurch weniger komplex ausgelegt werden. Ein vorzeitiges und unnötiges Auslösen der Fehlerstromschutzschaltung wird durch die Verwendung der erfindungsgemäßen Bedingung dennoch verhindert.

Nach dem Verbinden der DEA mit dem Netz kann die Bestimmung einer kapazitiven Ableitstromkomponente des Fehlerstromes der DEA in das Netz fortlaufend oder wiederholt bestimmt werden. Wenn die bestimmte kapazitive Ableitstromkomponente einen zweiten Grenzwert überschreitet, kann die DEA vorübergehend wieder vom Netz getrennt werden. Eine erneute Zuschaltung der DEA zu einem späteren Zeitpunkt kann insbesondere unter Verwendung des vorstehend beschriebenen erfindungsgemäßen Betriebsverfahrens durchgeführt werden.

Alternativ zu einer Trennung der DEA vom Netz kann ein Überschreiten des zweiten Grenzwertes durch die kapazitiven Ableitstromkomponente aber auch nur dafür Anlass geben, dass die Generatorspannung des Generators der DEA vorübergehend reduziert wird. Dies führt zwar nicht notwendigerweise zu einer Reduktion des kapazitiven Ableitstroms, wohl aber zu einer Reduzierung eines über einen Isolationswiderstand fließenden zusätzlichen Stromes, so dass auch durch diese Maßnahme die Wahrscheinlichkeit einer unnötigen Auslösung der Fehlerstromschutzschaltung reduziert ist. Hierdurch kann die DEA weiterhin Energie produzieren und die kapazitiven Ableitstromkomponente kann fortlaufend im Betrieb der DEA überwacht werden, sodass die Maßnahme der reduzierten Generatorspannung bei einem Unterschreiten des zweiten Grenzwertes unverzüglich wieder aufgehoben werden kann. Der Ertragsverlust durch die erforderliche Gegenmaßnahme kann also gering gehalten werden. Sollte der kapazitive Ableitstrom allerdings weiter steigen, kann die DEA selbstverständlich vor einer Auslösung der Fehlerstromschutzschaltung vom Netz getrennt werden.

In einer vorteilhaften Ausgestaltung des erfindungsgemäßen Verfahrens kann der zweite Grenzwert kleiner oder gleich der Hälfte einer nominalen Auslöseschwelle der Fehlerstromschutzschaltung der DEA gewählt werden. Hierdurch kann sichergestellt werden, dass die Fehlerstromschutzschaltung ohne Vorliegen eines Isolationsfehlers nicht ausschließlich aufgrund der kapazitiven Ableitstromkomponente im Betrieb der DEA auslöst, selbst dann, wenn die Fehlerstromschutzschaltung eine zulässig unterhalb der nominalen Auslöseschwelle liegende individuelle Auslöseschwelle aufweist.

Bevorzugt erfolgt die Bestimmung der Ableitkapazität gemeinsam mit einer Bestimmung eines Isolationswiderstandes des Generators. Die DEA weist zu diesem Zweck eine Isolationsüberwachung auf. Hierbei wird beispielsweise eine Spannungsamplitude mit einer Messfrequenz, die auch von der Netzfrequenz abweichen kann, zwischen einem Anschluss des Generators und einem Bezugspotenzial, vorzugweise einem Erdpotential angelegt. Durch Messung des hierdurch verursachten Stromes können durch die Isolationsüberwachung sowohl der Isolationswiderstand als auch die Ableitkapazität gemeinsam bestimmt werden.

Zur Bestimmung der Ableitkapazität können durch eine Wechselrichterbrücke eines Wechselrichters der DEA mindestens zwei Spannungswerte an Anschlussleitungen des Generators der DEA vorgegeben werden. Die durch die zwei Spannungswerte verursachten Ströme beziehungsweise Stromtransienten können zur Bestimmung der Ableitkapazität verwendet werden. Besonders bevorzugt ist die Vorgabe eines sinusförmigen Spannungsverlaufs mittels der Wechselrichterbrücke.

In einer vorteilhaften Ausführungsvariante der gemeinsamen Bestimmung von Ableitkapazität und Isolationswiderstand wird der Neutralleiteranschluss des Wechselrichters mit dem Neutralleiter des Netzes verbunden, während die Phasenanschlüsse getrennt bleiben. Anschließend kann über eine geeignete Ansteuerung der Wechselrichterbrücke eine Spannung einer vorgegebenen Amplitude und Frequenz an den Generatoranschlüssen angelegt werden. Der verursachte Strom kann mit ohnehin vorhandenen Stromsensoren erfasst und zur Bestimmung von Ableitkapazität und Isolationswiderstand in bekannter Weise ausgewertet werden.

Mit diesem Verfahren kann gleichzeitig auch die Auslöseschwelle der Fehlerstromschutzschaltung geprüft werden, indem die Amplitude der mit der Wechselrichterbrücke vorgegebenen Spannung bis zum Auslösen der Fehlerstromschutzschaltung schrittweise oder kontinuierlich gesteigert wird, bevorzugt unter Verwendung der Netzfrequenz als Messfrequenz. Die Amplitude des beim Auslösen der Fehlerstromschutzschaltung durch die Spannung verursachten Stromes bestimmt die Auslöseschwelle der Fehlerstromschutzschaltung. Sofern sichergestellt ist, dass die DEA bei der Durchführung dieses Verfahrens einen ausreichend hohen Isolationswiderstand aufweist, und somit der verursachte Strom lediglich die kapazitiven Ableitstromkomponente enthält, entspricht die Auslöseschwelle der Stromamplitude beim Auslösen der Fehlerstromschutzschaltung.

Bevorzugt wird der zweite Grenzwert in Abhängigkeit der so bestimmten Auslöseschwelle festgelegt, insbesondere indem der zweite Grenzwert um einen vorgegebenen Betrag oder einen vorgegebenen Prozentsatz gegenüber der bestimmten Auslöseschwelle reduziert ist.

In einer weiteren vorteilhaften Ausgestaltung des erfindungsgemäßen Verfahrens wird auf ein unnötiges Auslösen der Fehlerstromschutzschaltung im Betrieb der DEA mit einer Anpassung des ersten Grenzwertes reagiert, indem der erste Grenzwert in Abhängigkeit einer Differenz zwischen der beim letzten Zuschalten der DEA zum Netz bestimmten Ableitkapazität und dem bisherigen ersten Grenzwert erniedrigt wird. Insbesondere kann der erste Grenzwert um die gesamte Differenz oder um einen vorgegebenen Prozentsatz dieser Differenz erniedrigt werden. Auf diese Weise kann auf ein unnötiges Auslösen der Fehlerstromschutzschaltung aufgrund eines ungeeignet hoch gewählten ersten Grenzwertes reagiert werden, indem der erste Grenzwert automatisch auf einen für ein Verhindern eines unnötigen Auslösen der Fehlerstromschutzschaltung ausreichend niedrigen Wert reduziert wird.

Zur weiteren Verbesserung des Verfahrens können aktuelle Wetterdaten und/oder Daten zur Wetterprognose berücksichtigt werden. Beispielsweise kann der erste Grenzwert in Abhängigkeit dieser Daten gewählt sein. Hierdurch kann das Verfahren eine wetterbedingte Veränderung der beim Zuschalten bestimmten Ableitkapazität im Verlaufe der voraussichtlichen Betriebsdauer der DEA mit berücksichtigen und zum Beispiel ein Zuschalten der DEA unterlassen, wenn die Ableitkapazität bereits den ersten Grenzwert fast erreicht hat und eine weitere Erhöhung der Ableitkapazität aufgrund einsetzenden Niederschlages absehbar ist.

Alternativ zu einem Unterlassen der Zuschaltung der DEA zum Netz können die aktuellen Wetterdaten und/oder die Daten zur Wetterprognose auch dadurch berücksichtigt werden, dass die DEA sich zunächst mit dem Netz verbindet, aber bereits einen Zeitpunkt festlegt, zu dem sie sich wieder vom Netz trennt. Dieser Zeitpunkt entspricht dem Zeitpunkt einer prognostizierten Wetterveränderung, die voraussichtlich eine kritische Erhöhung der Ableitkapazität zur Folge hat. Dieses Vorgehen kann insbesondere dann gewählt werden, wenn die beim Zuschalten bestimmte Ableitkapazität um weniger als ein vorgegebener Abstandswert unterhalb des ersten Grenzwerts liegt.

In einem weiteren Aspekt umfasst die Erfindung eine DEA, die zur Durchführung des vorstehend beschriebenen Betriebsverfahrens eingerichtet ist. Durch die Verwendung des Verfahrens ist es möglich, auch solche Fehlerstromsensoren innerhalb der Fehlerstromschutzschaltung zu verwenden, bei denen keine Kompensation einer kapazitiven Ableitstromkomponente erfolgt. Dennoch ist es möglich, eine Auslösung der Fehlerstromschutzschaltung aufgrund einer überhöhten Ableitstromkomponente zuverlässig zu verhindern.

Vorteilhafterweise umfasst die DEA hierbei eine Isolationsüberwachung, die zur gemeinsamen Bestimmung eines Isolationswiderstandes und der Ableitkapazität eines Generators der DEA eingerichtet ist.

Im Folgenden wird die Erfindung mithilfe von Figuren dargestellt, von denen
- Fig. 1: eine erfindungsgemäße Ausführung einer DEA und
- Fig. 2: ein Ablaufdiagramm eines erfindungsgemäßen Betriebsverfahrens zeigen.

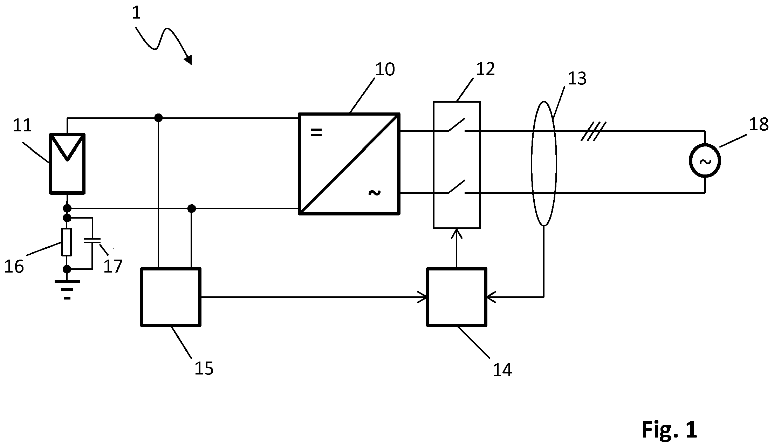

Fig. 1 zeigt eine DEA 1, die als Photovoltaikanlage mit einem Wechselrichter 10 gestaltet ist, wobei der Wechselrichter 10 mithilfe einer Wechselrichterbrücke den Gleichstrom eines Generators 11 in einen netzkonformen Wechselstrom zur Einspeisung in ein Netz 18 über Netzanschlussleitungen umwandelt. In Netzanschlussleitungen der DEA 1 ist ein Netzrelais 12 angeordnet, das über eine Fehlerstromschutzschaltung 14 angesteuert wird. Die Fehlerstromschutzschaltung 14 ist mit einem Fehlerstromsensor 13 verbunden, der einen Fehlerstrom auf den Netzanschlussleitungen feststellt und mit einem Schwellwert vergleicht, bei dessen Überschreitung das Netzrelais 12 geöffnet wird, um den Wechselrichter 10 vom Netz 18 zu trennen.

Weiterhin weist die DEA 1 eine Isolationsüberwachung 15 an den Verbindungsleitungen des Wechselrichters 10 zum Generator 11 auf, die dazu eingerichtet ist, vor dem Zuschalten der DEA 1 zum Netz 18 und/oder während des Betriebs der DEA 1 den Wert eines Isolationswiderstands 16 sowie den Wert einer Ableitkapazität 17 des Generators 11 gegenüber einem Erdpotential zu bestimmen. Der Isolationswiderstand und die Ableitkapazität stellen hierbei keine real vorhandenen Bauteile dar, sondern sollen als Ersatzschaltbild die elektrischen Eigenschaften der DEA repräsentieren und können auch an einer beliebigen anderen Stelle des Generators 11 angeschlossen sein.

In Abhängigkeit der derart bestimmten Werte des Isolationswiderstand 16 und der Ableitkapazität 17 übermittelt die Isolationsüberwachung 15 an die Fehlerstromschutzschaltung 14 ein Signal, das zur Ansteuerung des Netzrelais 12 verwendet wird. Insbesondere ist vorgesehen, dass bei Unterschreitung eines minimalen Isolationswiderstandes durch den Isolationswiderstand 16 oder bei Überschreiten einer maximalen Ableitkapazität durch die Ableitkapazität 17 das Netzrelais 12 nicht geschlossen wird oder geöffnet wird, falls es geschlossen ist.

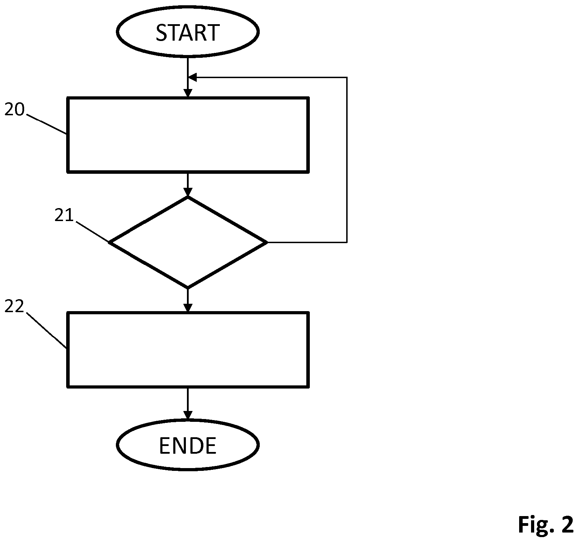

Fig. 2 zeigt ein erfindungsgemäßes Betriebsverfahren für eine DEA wie beispielsweise der in Fig. 1 gezeigten DEA 1. In einem ersten Schritt 20 wird zu Beginn des Verfahrens vor dem Verbinden der DEA die Ableitkapazität eines Generators in der DEA bestimmt. In einem zweiten Schritt 21 wird der derart bestimmte Wert der Ableitkapazität mit einem vorgegebenen ersten Grenzwert verglichen und bei dessen Überschreitung zurück zu Beginn des Verfahrens verzweigt und die Bestimmung der Ableitkapazität zu einem späteren Zeitpunkt wiederholt, ohne dass die DEA mit dem Netz verbunden wird.

In einem dritten Schritt 22 wird die DEA mit dem Netz verbunden, wenn die bestimmte Ableitkapazität kleiner oder gleich dem vorgegebenen Grenzwert ist.

An den dritten Schritt 22 können weitere Verfahrensschritte nach Inbetriebnahme der DEA anschließen, in der weiterhin die Ableitkapazität überwacht wird. Beispielsweise kann nach dem Verbinden der DEA mit dem Netz fortlaufend oder wiederholt eine kapazitiven Ableitstromkomponente eines Fehlerstromes der DEA bestimmt und bei Überschreiten eines zweiten Grenzwertes durch diese Ableitstromkomponente die Anlage vom Netz getrennt werden oder alternativ eine Generatorspannung des Generators reduziert werden.

Weiterhin können Fälle des Auslösen der Fehlerstromschutzschaltung der DEA dahingehend ausgewertet werden, dass der erste oder der zweite Grenzwert geeignet angepasst wird, wenn es weiterhin zu unnötigen Abschaltungen aufgrund einer zu hohen kapazitiven Ableitstromkomponente kommt.

Alternativ oder zusätzlich kann der zweite Grenzwert mit folgenden Schritten geeignet bestimmt werden: zunächst wird eine kapazitiven Ableitstromkomponente bestimmt, bei dem der Fehlerstromschutzschalter auslöst. Der Wert dieser Komponente wird insbesondere unter der Voraussetzung bestimmt, dass keine weiteren Ableitstromkomponenten vorhanden sind. Anschließend wird der zweite Grenzwert als ein um einen vorgegebenen Betrag oder um einen vorgegebenen Prozentsatz gegenüber der auslösenden kapazitiven Ableitstromkomponente reduzierten Wert festgelegt.

Weiterhin kann der erste Grenzwert in Abhängigkeit von aktuellen Wetterdaten und oder von Daten zur Wetterprognose gewählt werden. Auf diese Weise kann berücksichtigt werden, inwieweit die Ableitkapazität wetterbedingt gegenüber einer zum Zeitpunkt des Verbindens mit dem Netz bestimmten Ableitkapazität variieren kann, um die Möglichkeit einer Erhöhung der Ableitkapazität auf einen für eine Fehlerstromabschaltung kritischen Wert im Verlaufe der Betriebsdauer (in der Regel des verbleibenden Tages) abschätzen zu können. Auf diese Weise kann entschieden werden, auf den Ertrag der Anlage am betroffenen Tag zu verzichten, um den Aufwand eines manuellen Zurücksetzens der Fehlerstromschutzschaltung zu vermeiden. Ebenfalls denkbar ist es, geeignete Maßnahmen zur Vermeidung einer fehlerstrombedingten Abschaltung der DEA, beispielsweise dessen vorübergehende Trennung vom Netz, innerhalb eines aus der Wetterprognose bestimmten Zeitraums vorzusehen.

### Bezugszeichenliste

- 1: Dezentrale Energieerzeugungsanlage (DEA)
- 10: Wechselrichter
- 11: Generator
- 12: Netzrelais
- 13: Fehlerstromsensor
- 14: Fehlerstromschutzschaltung
- 15: Isolationsüberwachung
- 16: Isolationswiderstand
- 17: Ableitkapazität
- 18: Netz
- 20 - 22: Verfahrensschritt

## Patentansprüche

1. Betriebsverfahren durchgeführt durch eine dezentrale Energieerzeugungsanlage DEA (1) ausgestattet mit einer Fehlerstromüberwachung, das Betriebsverfahren umfassend die Schritte:
- vor einem Verbinden der DEA (1) mit einem Netz (18), Bestimmen einer Ableitkapazität eines Generators (11) der DEA (1),
- Vergleichen der bestimmten Ableitkapazität mit einem vorgegebenen ersten Grenzwert,
- Verbinden der DEA (1) mit dem Netz (18) nur dann, wenn die bestimmte Ableitkapazität kleiner als der vorgegebene erste Grenzwert ist.

2. Betriebsverfahren nach Anspruch 1, wobei die Bestimmung der Ableitkapazität gemeinsam mit einer Bestimmung eines Isolationswiderstandes des Generators (11) erfolgt.

3. Betriebsverfahren nach Anspruch 1 oder 2, wobei nach dem Verbinden der DEA (1) mit dem Netz (18) fortlaufend oder wiederholt eine kapazitive Ableitstromkomponente eines Fehlerstroms der DEA (1) bestimmt wird und wobei bei Überschreiten eines zweiten Grenzwertes durch die kapazitive Ableitstromkomponente die DEA (1) wieder vom Netz (18) getrennt wird.

4. Betriebsverfahren nach Anspruch 1 oder 2, wobei nach dem Verbinden der DEA (1) mit dem Netz (18) fortlaufend oder wiederholt eine kapazitive Ableitstromkomponente eines Fehlerstroms der DEA (1) bestimmt wird und wobei bei Überschreiten eines zweiten Grenzwertes durch die kapazitive Ableitstromkomponente eine Generatorspannung des Generators (11) reduziert wird.

5. Betriebsverfahren nach einem der vorangehenden Ansprüche, wobei der erste Grenzwert in Reaktion auf ein Auslösen einer Fehlerstromschutzschaltung (14) der DEA (1) in Abhängigkeit einer Differenz zwischen der zuletzt bestimmten Ableitkapazität und dem ersten Grenzwert erniedrigt wird.

6. Betriebsverfahren nach Anspruch 3 oder 4, wobei der zweite Grenzwert kleiner oder gleich der Hälfte einer nominalen Auslöseschwelle einer Fehlerstromschutzschaltung (14) der DEA (1) gewählt ist.

7. Betriebsverfahren nach einem der Ansprüche 3 oder 4, wobei der zweite Grenzwert mit folgenden Schritten bestimmt wird:
- Bestimmen einer kapazitiven Ableitstromkomponente, bei der die Fehlerstromschutzschaltung (14) der DEA (1) auslöst und
- Festlegen des zweiten Grenzwerts, der gegenüber der kapazitiven Ableitstromkomponente, bei der die Fehlerstromschutzschaltung (14) der DEA (1) auslöst, um einen vorgegebenen Betrag oder um einen vorgegebenen Prozentsatz reduziert ist.

8. Betriebsverfahren nach einem der vorangehenden Ansprüche, wobei die Bestimmung der Ableitkapazität durch Vorgabe von mindestens zwei Spannungswerten, insbesondere durch Vorgabe eines sinusförmigen Spannungsverlaufs durch eine Wechselrichterbrücke der DEA (1) erfolgt.

9. Betriebsverfahren nach Anspruch 8, wobei die Wechselrichterbrücke netzseitig während der Bestimmung der Ableitkapazität mit einem Neutralleiter des Netzes (18) verbunden ist.

10. Betriebsverfahren nach einem der vorangehenden Ansprüche, wobei der erste Grenzwert in Abhängigkeit von aktuellen Wetterdaten und/oder von Daten zur Wetterprognose gewählt ist.

11. Betriebsverfahren nach einem der vorangehenden Ansprüche, wobei im Fall des Verbindens mit dem Netz (18) und wenn die bestimmte Ableitkapazität um weniger als einen vorgegebenen Abstandswert unterhalb des ersten Grenzwertes liegt, anhand von Daten zur Wetterprognose ein Zeitpunkt gewählt wird, zu dem die DEA (1) wieder vom Netz (18) getrennt wird.

12. Dezentrale Energieerzeugungsanlage (1) ausgestattet mit einer Fehlerstromüberwachung, wobei die dezentrale Energieerzeugungsanlage zur Durchführung des Verfahrens nach einem der vorangehenden Ansprüche eingerichtet ist.

13. Dezentrale Energieerzeugungsanlage (1) nach Anspruch 12, die einen gegenüber einer kapazitiven Ableitstromkomponente unkompensierten Fehlerstromsensor (13) aufweist.

14. Dezentrale Energieerzeugungsanlage nach Anspruch 12 oder 13, umfassend eine Isolationsüberwachung (15) zur gemeinsamen Bestimmung eines Isolationswiderstandes und der Ableitkapazität des Generators (11).

## Claims

1. Operating method performed by a decentralized power generation plant DG (1), equipped with a residual current monitor, the operating method comprising the steps:
- before connecting the DG (1) to a grid (18), determining a leakage capacitance of a generator (11) of the DG (1),
- comparing the determined leakage capacitance with a predetermined first limit value,
- connecting the DG (1) to the grid (18) only if the determined leakage capacitance is smaller than the predetermined first limit value.

2. Operating method according to claim 1, wherein the determination of the leakage capacitance is carried out together with a determination of an insulation resistance of the generator (11).

3. Operating method according to claims 1 or 2, wherein after connecting the DG (1) to the grid (18), a capacitive leakage current component of a residual current of the DG (1) is determined continuously or repeatedly, and wherein when a second limit value is exceeded by the capacitive leakage current component, the DG (1) is disconnected from the grid (18) again.

4. Operating method according to claims 1 or 2, wherein after connecting the DG (1) to the grid (18), a capacitive leakage current component of a residual current of the DG (1) is determined continuously or repeatedly, and wherein when a second limit value is exceeded by the capacitive leakage current component, a generator voltage of the generator (11) is reduced.

5. Operating method according to one of the preceding claims, wherein the first limit value is lowered in response to a tripping of a residual current circuit breaker (14) of the DG (1) as a function of a difference between the last determined leakage capacitance and the first limit value.

6. Operating method according to one of the preceding claims, wherein the second limit value is selected to be less than or equal to half of a nominal tripping threshold of a residual current circuit breaker (14) of the DG (1).

7. Operating method according to claims 3 or 4, wherein the second limit value is determined with the following steps:
- determining a capacitive leakage current component at which the residual current circuit breaker (14) of the DG (1) trips, and-
- determining the second limit value which is reduced by a predetermined amount or by a predetermined percentage
compared to the capacitive leakage current component at which the residual current circuit breaker (14) of the DG (1) trips.

8. Operating method according to one of the preceding claims, wherein the leakage capacitance is determined by presetting at least two voltage values, in particular by presetting a sinusoidal voltage characteristic by an inverter bridge of the DG (1).

9. Operating method according to claim 8, wherein the inverter bridge on the grid side is connected to a neutral conductor of the grid (18) during the determination of the leakage capacitance.

10. Operating method according to one of the preceding claims, the first limit value being selected in dependence on current weather data and/or weather forecast data.

11. Operating method according to one of the preceding claims, wherein in the case of connection to the grid (18) and if the determined leakage capacitance is below the first limit value by less than a predetermined distance value, a time at which the DG (1) is disconnected from the grid (18) again is selected on the basis of data for weather forecasting.

12. Decentralised power generation plant (1) equipped with a residual current monitor, wherein the decentralised power generation plant (1) is configured to perform the method according to one of the preceding claims.

13. Decentralized power generation plant (1) according to claim 12, comprising a residual current sensor (13) which is uncompensated with respect to a capacitive leakage current component.

14. Decentralized power generation system according to claims 12 or 13, comprising an insulation monitoring system (15) for jointly determining an insulation resistance and the leakage capacitance of the generator (11).

## Revendications

1. Procédé de fonctionnement réalisé par un système de production énergétique décentralisé DEA (1) équipé d'une surveillance de courant de défaut, le procédé d'exploitation comprenant les étapes suivantes :
- avant une connexion du DEA (1) à un réseau (18), détermination d'une capacité de fuite d'un générateur (11) du DEA (1),
- comparaison de la capacité de fuite déterminée à une première valeur limite prédéfinie,
- connexion du DEA (1) au réseau (18) uniquement si la capacité de fuite déterminée est inférieure à la première valeur limite prédéfinie.

2. Procédé de fonctionnement selon la revendication 1, dans lequel la détermination de la capacité de dérivation est effectuée conjointement avec une détermination d'une résistance d'isolement du générateur (11).

3. Procédé de fonctionnement selon la revendication 1 ou 2, dans lequel, après la connexion du DEA (1) au réseau (18), une composante de courant de fuite capacitive d'un courant de défaut du DEA (1) est déterminée de manière continue ou répétée et dans lequel, en cas de dépassement d'une deuxième valeur limite par la composante de courant de fuite capacitive, le DEA (1) est à nouveau déconnectée du réseau (18).

4. Procédé de fonctionnement selon la revendication 1 ou 2, dans lequel, après la connexion du DEA (1) au réseau (18), une composante de courant de fuite capacitive d'un courant de défaut du DEA (1) est déterminée de manière continue ou répétée et dans lequel, en cas de dépassement d'une deuxième valeur limite par la composante de courant de fuite capacitive, une tension de générateur du générateur (11) est réduite.

5. Procédé de fonctionnement selon l'une des revendications précédentes, dans lequel la première valeur limite est abaissée en réaction à un déclenchement d'un circuit de protection contre les courants de défaut (14) du DEA (1) en fonction d'une différence entre la capacité de dérivation déterminée en dernier lieu et la première valeur limite.

6. Procédé de fonctionnement selon la revendication 3 ou 4, dans lequel la deuxième valeur limite est choisie inférieure ou égale à la moitié d'un seuil nominal de déclenchement d'un circuit de protection contre les courants de défaut (14) du DEA (1).

7. Procédé de fonctionnement selon l'une des revendications 3 ou 4, dans lequel la deuxième valeur limite est déterminée par les étapes suivantes :
- Détermination d'une composante de courant de fuite capacitif à laquelle le circuit de protection contre les courants de défaut (14) du DEA (1) se déclenche, et
- Détermination de la deuxième valeur limite qui est réduite d'une valeur prédéterminée ou d'un pourcentage prédéterminé par rapport à la composante de courant de fuite capacitif à laquelle le circuit de protection contre les courants de défaut (14) du DEA (1) se déclenche.

8. Procédé de fonctionnement selon l'une des revendications précédentes, dans lequel la détermination de la capacité de dérivation s'effectue en prédéfinissant au moins deux valeurs de tension, notamment en prédéfinissant une courbe de tension sinusoïdale à travers un pont onduleur du DEA (1).

9. Procédé de fonctionnement selon la revendication 8, dans lequel le pont onduleur est relié, côté réseau, à un conducteur neutre du réseau (18) pendant la détermination de la capacité de fuite.

10. Procédé de fonctionnement selon l'une des revendications précédentes, dans lequel la première valeur limite est choisie en fonction de données météorologiques actuelles et/ou de données relatives aux prévisions météorologiques.

11. Procédé de fonctionnement selon l'une des revendications précédentes, dans lequel, en cas de connexion au réseau (18) et lorsque la capacité de dérivation déterminée est inférieure à la première valeur limite de moins d'une valeur de distance prédéterminée, on choisit, à l'aide de données relatives aux prévisions météorologiques, un moment auquel le DEA (1) est à nouveau déconnectée du réseau (18).

12. Système de production énergétique décentralisé (1) équipé d'une surveillance de courant de défaut, le système de production énergétique décentralisé étant aménagé pour la mise en oeuvre du procédé selon l'une des revendications précédentes.

13. Système de production énergétique décentralisé (1) selon la revendication 12, qui comporte un capteur de courant de défaut (13) non compensé par rapport à une composante de courant de fuite capacitive.

14. Système de production énergétique décentralisé selon la revendication 12 ou 13, comprenant un dispositif de surveillance d'isolement (15) pour déterminer conjointement une résistance d'isolement et la capacité de fuite du générateur (11).
